# EUROPÄISCHE PATENTSCHRIFT

(11) **EP 2 194 594 B1**
(45) Veröffentlichungstag und Bekanntmachung des Hinweises auf die Patenterteilung: **11.05.2016**
(21) Anmeldenummer: 09013289.5
(22) Anmeldetag: 03.08.2007
(51) Int. Cl.: B29C 45/14, H01L 51/56

(54) **Verfahren zur Herstellung eines dreidimensionalen Bauteils**
Method for producing a three-dimensional component
Procédé de fabrication d'un composant tridimensionnel

(30) Priorität: 14.08.2006 DE 102006037998
(43) Veröffentlichungstag der Anmeldung: 09.06.2010
(62) Teilanmeldung aus: 07802489.0
(73) Patentinhaber: Franz Binder GmbH & Co. Elektrische Bauelemente KG, 74172 Neckarsulm (DE)
(72) Erfinder: Hartmann, Manfred, 85238 Ziegelberg/Petershausen (DE); Schlarb, Andreas, 52134 Herzogenrath (DE); Finke, Hans Michael, 74834 Elztal-Auerbach (DE); Grunow Werner, 74078 Heilbronn (DE)
(74) Vertreter: Patent- und Rechtsanwälte Ullrich & Naumann

(56) Entgegenhaltungen:
- EP-A- 1 505 664
- EP-A- 1 568 750
- WO-A-03/037039
- DE-A1- 4 430 907
- GB-A- 775 190

## Beschreibung

Die vorliegende Erfindung betrifft ein Verfahren zur Herstellung einer dreidimensional geformten elektrolumineszierend leuchtenden Oberfläche, wobei eine dreidimensional geformte, mit Elektrolumineszenz-Funktionsschichten ausgestattete Oberfläche mindestens mit einer Abschlusselektrodenschicht versehen wird.

Elektrolumineszierende Folien bestehen im Grundaufbau aus mindestens folgenden Schichten: Einer Grundfolie, einer ersten Elektrodenschicht, einer Schicht mit Leuchtpigmenten, einer zweiten, transparenten Elektrodenschicht und einer transparenten Deckfolie. Zusätzliche Hilfsschichten wie Barriereschichten und/oder Dielektrika können vorhanden sein. Weiterhin können die Deck- und/oder Grundfolien gleichzeitig als Elektrodenschichten dienen. All diese Schichten werden im Folgenden auch als Funktionsschichten bezeichnet. Als Funktionsschichten sind dabei all die Schichten definiert, die im jeweiligen Anwendungsfall notwendig sind, um eine Elektrolumineszenzwirkung des Folienaufbaus zu realisieren; insbesondere die Elektrodenschichten und die Schicht mit Leuchtpigmenten: Durch Anlegen einer Spannung - bei anorganischen elektrolumineszierenden Aufbauten einer Wechselspannung- wird ein elektrisches Feld erzeugt, das die Leuchtpigmentschicht zur Lichtemission durch die transparente Elektrode hindurch anregt.

Zusätzlich zum vertikalen Schichtaufbau ist oft eine Strukturierung der Fläche ebenfalls notwendig: Hierzu muss eine Segmentierung der Elektrodenschicht vorgenommen werden, während die Leuchtpigmentschicht sowohl segmentiert als auch unsegmentiert strukturiert ansteuerbar ist. Eine Segmentierung der Pigmentschicht erfolgt üblicherweise durch Verdruckung unterschiedlicher Farbpigment-Segmente, während die Elektrodenschichten durch Unterbrechung der elektrischen Kontakte innehalb der Schicht und Einzelkontaktierung der so gewonnenen Segmente erfolgt. Ein solch flacher Substrataufbau ist aufgrund der Komplexität der Schichten und der Segmentierung ein Produkt, das sich nur bis zu einem gewissen Grade zur Verformung in die dritte Dimension eignet. Eine Verwendung elektrolurnineszierender Folien ist aber auch in Anwendungen gewünscht, wo Dekor-Bauteile unebene Oberflächen aufweisen. Eine Verklebung von elektrolumineszierenden Folien auf derartige Bauteile ist jedoch nur dann möglich, wenn das Bauteil keine allzu unregelmäßigen Unebenheiten oder keine starken Oberflächenkrümmungen aufweist, da bei der Applikation sonst leicht Luftblasen eingeschlossen werden oder weil sich der klebende elektrolumineszierende Verbund am Rande aufstellt.

EP1568750 A2 betrifft eine verformbare elektrolumineszierende Anordnung enthaltend eine transparente Trägerfolie, eine transparente Elektrode, eine elektrolumineszierende Schicht, eine Dielektrikaschicht und eine Gegenelektrode.

DE 19717740 A1 offenbart ein Verfahren, bei dem eine elektrolumineszierende Folie im sogenannten Inmould-Verfahren in eine Spritzgussform eingelegt und mit einem heißen, flüssigen Kunststoff hinterspritzt wird. Die Folie kann hierzu im Vorfeld durch Tiefziehen bereits verformt worden sein. Hierbei stellen sich jedoch folgende Probleme:
Erstens kann der komplexe Folienaufbau durch den heißen flüssigen Kunststoff leicht beschädigt werden. Zudem treten lokal hohe Temperaturspitzen auf, was lokal Beschädigungen des Folienaufbaus hervorrufen und damit eine Unbrauchbarkeit des gesamten Bauteils zur Folge haben kann.

Zweitens ist bereits das Verformen (z.B. Tiefziehen) von elektrolumineszierenden Folien technisch riskant: Die Funktionsschichten können mechanisch in sich zerstört werden, wodurch ggf. die Funktionsfähigkeit des gesamten Folienaufbaus in Frage steht. Speziell die Elektrodenschichten, vor allem die oben beschriebene erste Elektrodenschicht (Rückelektrode), sind besonders anfällig für Brüche, doch auch eine Beschädigung von Sperrschichten, Kontaktierungen oder der Pigmentschicht kann zur Folge haben, dass die elektrolumineszierende Folie im ganzen oder teilweise nicht mehr zum Leuchten angeregt werden kann.

Drittens unterliegen alle oben beschriebenen bekannten Formen der Anpassung einer elektrolumineszierende Folie auf einen dreidimensionalen Untergrund engen Grenzen: Die Anpassung an beliebig gestaltete, sehr unregelmäßige Topologien, d.h. auch an Oberflächen, die mehrere, in ihrer Größe und Gestalt unterschiedliche Hügel aufweisen, ist mit diesen Technologien nicht durchführbar.

Der Erfindung liegt daher die Aufgabe zugrunde, ein dreidimensionales Bauteil so mit einem Elektrolumineszenz-Aufbau auszustatten, dass prozesssicher und auch bei sehr unregelmäßigen Oberflächenstrukturen, die ein einfaches Aufkleben oder Aufkaschieren einer Folie nicht zulassen, ein lichtemittierender Formkörper entsteht.

Die Aufgabe wird erfindungsgemäß durch ein Verfahren nach Anspruch 1 gelöst.

Das erfindungsgemäße Verfahren wird im Folgenden anhand der Figuren 1 bis 3 verdeutlicht. Dabei sind die Zeichnungen nicht maßstäblich zu verstehen; vielmehr sind der Anschaulichkeit wegen speziell die Schichtdicken von Folien und Druckschichten extrem vergrößert dargestellt. Es zeigen:
**Figur 1** den Schichtaufbau eines Folienrohlings für einen erfindungsgemäßen Herstellungsprozeß,
**Figur 2** ein Zwischenprodukt in diesem Prozeß,
**Figur3** das Endprodukt dieses Prozesses.

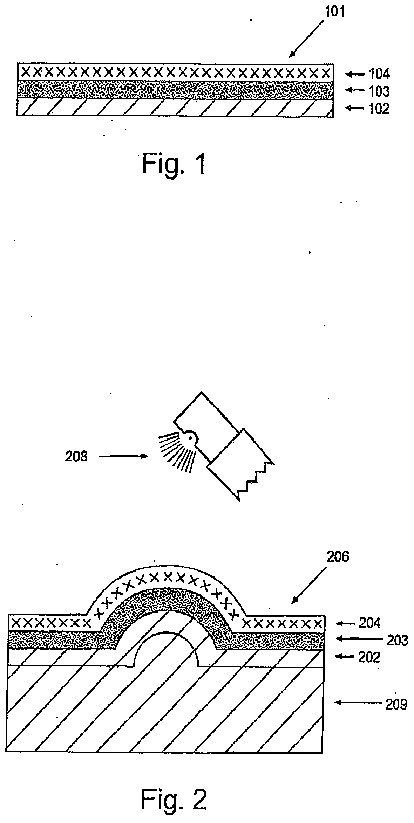

In **Figur 1** wird ein Folienrohling 101 dargestellt, der aus folgenden drei Schichten besteht: Auf einer Unterfolie 102 ist eine erste Elektrodenschicht 103 aufgebracht, auf der (ggf. unter Bereitstellung weiterer Zwischenschichten wie beispielsweise Barriereschichten) eine Leuchtpigmentschicht 104 aufgedruckt oder aufgetragen ist.

Folienrohling 101 ist ein Vorprodukt für einen kompletten Elektrolumineszenz-Schichtaufbau. Als Folienrohling für ein erfindungsgemäßes Verfahren kann im Endeffekt jeder Aufbau gesehen werden, der mindestens eine Elektrode 103 aufweist. Er können jedoch bereits weitere Elektrolumineszenz-Funktionsschichten vorliegen. Als Folienrohling wird er deshalb bezeichnet, weil eine abschließende zweite Elektrodenschicht nicht vorliegt, so dass der Aufbau nicht als Leuchtfolie funktionsfähig ist.

In **Figur 2** wird der Folienrohling nach einem Verformungs- und Hinterspritzungs-Vorgang als dreidimensionaler Bauteil-Rohling 206 dargestellt. Die Schichten 202 bis 204 sind analog zu Figur 1 zu verstehen, wobei die Unterfolie 202 mit einer Spritzgussmasse 209 hinterspritzt und dadurch mit ihr verbunden ist.

Nachdem der Bauteil-Rohling 206 vorliegt, wird nun der Elektrolumineszenz-Schichtaufbau auf der Seite des Folienrohlings, die der Spritzgussmasse gegenüberliegt, vervollständigt: Dies kann bei einfachen Geometrien durch Auflaminieren erfolgen, bevorzugt jedoch durch Druck- oder Sprühverfahren, hier angedeutet durch eine Sprühdüse 208.

Im Sprühverfahren können voll- oder teilflächig eine zweite (Abschluß-) Elektrodenschicht sowie gegebenenfalls weitere Funktionsschichten aufgebracht werden. Druckverfahren bieten sich vor allem dann an, wenn nur in Teilbereichen Schichten aufgebracht werden sollen oder besonders komplizierte Oberflächen bearbeitet werden: Erfindungsgemäß sind als Druckverfahren bevorzugt Sieb-, Tampon- oder Digitaldruck zu verwenden. Aufgrund der möglichen starken Unebenheiten ist besonders der Digitaldruck eine geeignete Maßnahme, um das Druckbild durch flexible Vorausberechnung an die Oberfläche anzupassen. Insbesondere Tintenstrahl-Druckverfahren werden hierzu bevorzugt.

Weitere mögliche Aufbringungsverfahren sind auch das Aufdampfen sowie das Aufrakeln einer oder das Eintauchen in eine Flüssigkeit oder Paste, die sich auf der Oberfläche absetzt und aushärtet.

Im hier vorliegenden Aufbau wird als Elektrodenschicht eine mindestens teilweise transparente Schicht aufgebracht, da die Elektrolumineszenz-Lichtabstrahlung weg vom Spritzgussteil (in der Zeichnung nach oben) erfolgen soll. Besonders bevorzugt wird hierzu ein transparenter Leitlack.

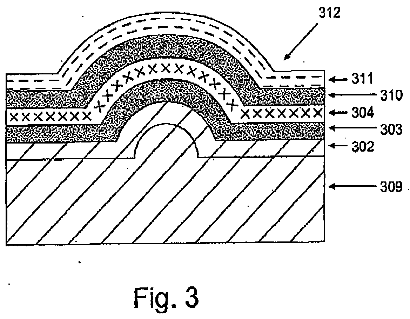

In Figur 3 ist das Endprodukt des Verfahrens dargestellt; ein dreidimensionales Bauteil 312 mit einem fest damit verbundenen Elektrolumineszenz-Schichtaufbau, bestehend aus mindestens folgenden Funktionsschichten: Die mit dem Spritzguß durch Zusammenschmelzen verbundene Unterfolie 302 und die Elektrode 303 sowie die Leuchtpigmentschicht 304. Hinzu kommen eine zweite Elektrodenschicht 310 und eine Deckfolie 311.

Die hier beschriebene erfindungsgemäße Vorgehensweise hat den Vorteil, dass besonders empfindliche Schichten eines Elektrolumineszenz-Aufbaus nicht durch Verformung überbeansprucht werden. Sie werden vielmehr erst nach Vorliegen der endgültigen Bauteil-Form hinzugefügt. Diese erfinderische Grundidee beschränkt sich daher bei weitem nicht auf die hier illustrierten Folienaufbauten oder auf hinterspritzte Folien. Als Grundprinzip gilt das Vorliegen eines Körpers mit einer unebenen Oberfläche, auf dem Elektrolumineszenz-Funktionsschichten vorliegen und der durch geeignete Aufbringungsverfahren dahingehend vervollständigt wird, dass der Rest der Funktionsschichten, die für einen funktionsfähigen Elektrolumineszenz-Aufbau notwendig sind, aufgebracht wird, insbesondere eine abschließende Elektrode.

Dies bedeutet insbesondere, dass ein Folienaufbau auch von der anderen Seite her, d.h. von einer tiefgezogenen Deckfolie mit erster transparenter Elektrodenschicht erfolgen kann, auf die dann die Funktionsschichten in entgegengesetzter Reihenfolge aufgebracht werden und dann auf der der Deckfolie entgegengesetzten Seite eine Hinterspritzung erfolgt. Diese Erfindungsvariante ist insofern besonders bevorzugt, als sich die sogenannte (üblicherweise opake) Rückelektrode als die empfindlichste Funktionsschicht erwiesen hat.

Eine weitere Ausführungsform der Erfindung ist die Vervollständigung eines starren dreidimensionalen Bauteils, welches ebenfalls mindestens eine Elektrolumineszenz-Funktionsschicht aufweist, zu einem Elektrolumineszenz-Funktionsteil. Beispielsweise können Spritzgussteile oder tiefgezogene Kunststoffplatten als derartige starre dreidimensionale Bauteile gelten.

Auch hier wird durch die Anwendung des erfindungsgemäßen Verfahrens erreicht, dass der Elektrolumineszenz-Aufbau ohne Funktionsrisiko in dreidimensionaler Form vorgelegt wird.

## Patentansprüche

1. Verfahren zur Herstellung einer dreidimensional geformten elektrolumineszierend leuchtenden Oberfläche unter Verwendung eines mindestens eine Elektrodenschicht (103) aufweisenden Folienrohlings (101), wobei eine dreidimensional geformte, mit Elektrolumineszenz-Funktionsschichten ausgestattete Oberfläche mindestens mit einer Abschlusselektrodenschicht (310) versehen wird, **dadurch gekennzeichnet, dass** mindestens eine der Funktions- und/oder Elektrodenschichten (304, 310) nach Vorliegen der endgültigen Bauteil-Form im Tampondruckverfahren aufgebracht wird, um die elektrolumineszierend leuchtende Oberfläche zu vervollständigen.

2. Verfahren gemäß Anspruch 1, **dadurch gekennzeichnet, dass** zusätzlich weitere Elektrolumineszenz-Funktionsschichten (303, 304) vor der Ausstattung der Oberfläche mit der Abschluß-Elektrodenschicht (310) aufgebracht werden.

3. Verfahren gemäß Anspruch 2, **dadurch gekennzeichnet, dass** als weitere Elektrolumineszenz-Funktionsschicht eine Leuchtpigmentschicht (304) aufgebracht wird.

4. Verfahren gemäß Ansprüchen 2 oder 3, **dadurch gekennzeichnet, dass** als weitere Elektrolumineszenz-Funktionsschicht eine Barriereschicht aufgebracht wird.

5. Verfahren gemäß Ansprüchen 2 bis 4, **dadurch gekennzeichnet, dass** als weitere Elektrolumineszenz-Funktionsschicht ein Dielektrikum verwendet wird.

6. Verfahren gemäß einem der vorhergehenden Ansprüche, **dadurch gekennzeichnet, dass** es sich bei der Abschluß-Elektrodenschicht (310) um eine mindestens teilweise transparente Schicht handelt.

7. Verfahren gemäß Anspruch 6, **dadurch gekennzeichnet, dass** es sich bei der mindestens teilweise transparenten Schicht um einen transparenten Leitlack handelt.

8. Verfahren gemäß einem der Ansprüche 1 bis 4, **dadurch gekennzeichnet, dass** es sich bei der Abschluß-Elektrodenschicht (310) um eine opake Schicht handelt.

9. Verfahren gemäß einem der vorhergehenden Ansprüche, **dadurch gekennzeichnet, dass** die gekrümmte Oberfläche dadurch hergestellt wird, dass ein flaches Substrat mit mindestens einer ersten Elektrodenschicht (103, 203, 303) ausgestattet und dann verformt wird.

10. Verfahren gemäß Anspruch 9, **dadurch gekennzeichnet, dass** nach dem Aufbringen der Abschluß-Elektrodenschicht (310) und gegebenenfalls weitere Schutzschichten eine Hinterspritzung des Werkstücks erfolgt.

11. Verfahren gemäß Anspruch 10, **dadurch gekennzeichnet, dass** die Hinterspritzung auf der Seite des Werkstücks erfolgt, auf der zwischen der Abschluß-Elektrodenschicht und der zu hinterspritzenden Oberfläche keine Elektrolumineszenz-Pigmentschicht liegt.

12. Verfahren gemäß Anspruch 10, **dadurch gekennzeichnet, dass** die Hinterspritzung auf der Seite des Werkstücks erfolgt, auf der zwischen der Abschluß-Elektrodenschicht und der zu hinterspritzenden Oberfläche eine Elektrolumineszenz-Pigmentschicht liegt.

13. Verfahren nach einem der Ansprüche 1 bis 12, **dadurch gekennzeichnet, dass** mindestens eine der Funktions- und/oder Elektrodenschichten (303, 304, 310) im Siebdruck aufgebracht wird, wobei mindestens eine der Funktions- und/oder Elektrodenschichten (303, 304, 310) im dreidimensionalen Siebdruck aufgebracht wird.

14. Verfahren nach einem der Ansprüche 1 bis 13, **dadurch gekennzeichnet, dass** mindestens eine der Funktions- und/oder Elektrodenschichten (303, 304, 310) im Digitaldruck und/oder im Tintenstrahldruck aufgebracht wird.

15. Verfahren gemäß einem der vorhergehenden Ansprüche, **dadurch gekennzeichnet, dass** mindestens eine der Funktions- und/oder Elektrodenschichten (303, 304, 310) durch Aufsprühen und/oder durch aufgalvanisieren und/oder durch Eintauchen in eine Flüssigkeit, die sich auf der Oberfläche absetzt, und/oder durch Aufrakeln und/oder durch Auflaminieren aufgebracht wird.

## Claims

1. Method for producing a three-dimensionally formed electroluminescent surface using a foil blank (101) having at least one electrode layer (103), wherein a three-dimensionally formed surface equipped with electroluminescent functional layers is provided with at least one terminal electrode layer (310),
**characterised in that** at least one of the functional and/or electrode layers (304, 310), once the component has its final form, is applied by the pad printing method in order to complete the electroluminescent surface.

2. Method according to claim 1, **characterised in that** further electroluminescent functional layers (303, 304) are additionally applied before the surface is equipped with the terminal electrode layer (310).

3. Method according to claim 2, **characterised in that** a luminous pigment layer (304) is applied as a further electroluminescent functional layer.

4. Method according to claim 2 or 3, **characterised in that** a barrier layer is applied as a further electroluminescent functional layer.

5. Method according to claims 2 to 4, **characterised in that** a dielectric is used as a further electroluminescent functional layer.

6. Method according to any one of the preceding claims, **characterised in that** the terminal electrode layer (310) is an at least partially transparent layer.

7. Method according to claim 6, **characterised in that** the at least partially transparent layer is a transparent conductive coat.

8. Method according to any one of claims 1 to 4, **characterised in that** the terminal electrode layer (310) is an opaque layer.

9. Method according to any one of the preceding claims, **characterised in that** the curved surface is produced by providing a flat substrate with at least a first electrode layer (103, 203, 303) and then shaping it.

10. Method according to claim 9, **characterised in that**, after application of the terminal electrode layer (310) and optionally further protective layers, back injection moulding of the workpiece is carried out.

11. Method according to claim 10, **characterised in that** the back injection moulding takes place on the side of the workpiece on which there is no electroluminescent pigment layer between the terminal electrode layer and the surface to be back injection moulded.

12. Method according to claim 10, **characterised in that** the back injection moulding takes place on the side of the workpiece on which there is an electroluminescent pigment layer between the terminal electrode layer and the surface to be back injection moulded.

13. Method according to any one of claims 1 to 12, **characterised in that** at least one of the functional and/or electrode layers (303, 304, 310) is applied by screen printing, wherein at least one of the functional and/or electrode layers (303, 304, 310) is applied by three-dimensional screen printing.

14. Method according to any one of claims 1 to 13, **characterised in that** at least one of the functional and/or electrode layers (303, 304, 310) is applied by digital printing and/or by inkjet printing.

15. Method according to any one of the preceding claims, **characterised in that** at least one of the functional and/or electrode layers (303, 304, 310) is applied by spraying and/or by galvanising and/or by dipping into a liquid which is deposited on the surface, and/or by knife application and/or by lamination.

## Revendications

1. Procédé de fabrication d'une surface lumineuse électroluminescente tridimensionnelle à l'aide d'une ébauche de feuille (101) comprenant au moins une couche d'électrode (103), une surface tridimensionnelle, munie de couches fonctionnelles à électroluminescence, étant munie d'au moins une couche d'électrode finale (310), **caractérisé en ce qu'**au moins une des couches fonctionnelles et/ou des couches d'électrode (304, 310) est appliquée, après la réalisation de la forme définitive du composant, à l'aide d'un procédé de tampographie afin de compléter la surface lumineuse électroluminescente.

2. Procédé selon la revendication 1, **caractérisé en ce que** des couches fonctionnelles électroluminescentes (303, 304) supplémentaires sont appliquées avant l'équipement de la surface avec la couche d'électrode finale (310).

3. Procédé selon la revendication 2, **caractérisé en ce que**, en tant que couche fonctionnelle électroluminescente supplémentaire, une couche de pigments lumineux (304) est appliquée.

4. Procédé selon les revendications 2 ou 3, **caractérisé en ce que**, en tant que couche fonctionnelle électroluminescente supplémentaire, une couche de barrière est appliquée.

5. Procédé selon les revendications 2 à 4, **caractérisé en ce que**, en tant que couche fonctionnelle électroluminescente supplémentaire, un diélectrique est utilisé.

6. Procédé selon l'une des revendications précédentes, **caractérisé en ce que** la couche d'électrode finale (310) est une couche au moins partiellement transparente.

7. Procédé selon la revendication 6, **caractérisé en ce que** la couche au moins partiellement transparente est un vernis conducteur transparent.

8. Procédé selon l'une des revendications 1 à 4, **caractérisé en ce que** la couche d'électrode finale (310) est une couche opaque.

9. Procédé selon l'une des revendications précédentes, **caractérisé en ce que** la surface incurvée est réalisée en équipant un substrat plat avec au moins une première couche d'électrode (103, 203, 303) puis en le déformant.

10. Procédé selon la revendication 9, **caractérisé en ce que**, après l'application de la couche d'électrode finale (310) et, le cas échéant, de couches de protection supplémentaires, une injection arrière de la pièce est effectuée.

11. Procédé selon la revendication 10, **caractérisé en ce que** l'injection arrière a lieu sur le côté de la pièce sur lequel aucune couche de pigments électroluminescents ne se trouve entre la couche d'électrode finale et la surface à injecter.

12. Procédé selon la revendication 10, **caractérisé en ce que** l'injection arrière a lieu sur le côté de la pièce sur lequel une couche de pigments électroluminescents se trouve entre la couche d'électrode finale et la surface à injecter.

13. Procédé selon l'une des revendications 1 à 12, **caractérisé en ce qu'**au moins une des couches fonctionnelles et/ou d'électrodes (303, 304, 310) est appliquée par sérigraphie, au moins une des couches fonctionnelles et/ou d'électrodes (303, 304, 310) étant appliquée par sérigraphie tridimensionnelle.

14. Procédé selon l'une des revendications 1 à 13, **caractérisé en ce qu'**au moins une des couches fonctionnelles et/ou d'électrodes (303, 304, 310) est appliquée par impression numérique et/ou par impression à jet d'encre.

15. Procédé selon l'une des revendications précédentes, **caractérisé en ce qu'**au moins une des couches fonctionnelles et/ou d'électrodes (303, 304, 310) est appliquée par pulvérisation et/ou par galvanisation et/ou par immersion dans un liquide qui se dépose sur la surface et/ou par raclage et/ou par stratification.
